# EUROPEAN PATENT APPLICATION

(11) **EP 0 584 869 A1**
(43) Date of publication of application: **02.03.1994**
(21) Application number: 93202433.4
(22) Date of filing: 18.08.1993
(51) Int. Cl.: H01J 37/20

(54) **Specimen holder for a particle-optical apparatus**

(30) Priority: 27.08.1992 EP 92202609
(71) Applicant: Philips Electronics N.V., 5621 BA Eindhoven (NL)
(72) Inventor: Nederlof, Frank, NL-5656 AA Eindhoven (NL)
(74) Representative: Bakker, Hendrik

(57) **Abstract**

A specimen holder for a particle-optical apparatus, for example an electron microscope. The motions of the specimen 6 are realised in known manner by motions of a tubular housing 2 in a ball joint 8. In order to achieve a suitably defined and suitably reproducible motion of the specimen 6 in the x-direction, a rod-shaped specimen support 3 is supported in V-grooves 11, 22 in the housing. Moreover, for the x-motion the vacuum passage is constructed so as to be static in that the specimen support 3 is connected to the housing 2 *via* a bellows 20. Static vacuum sealing is then provided by an O-ring 18.

## Description

The invention relates to a particle-optical apparatus with a specimen holder which comprises a housing which is movable relative to the apparatus in a first and a second, mutually perpendicular direction, and a rod-shaped specimen support for supporting the specimen, which support is accommodated in the tubular housing and is movable in a third direction, perpendicularly to the first and the second direction, said specimen support being supported, by way of its end facing the optical axis of the apparatus, in a V-groove whose groove direction is the third direction.

The invention also relates to a specimen holder for such a particle-optical apparatus.

A specimen support of this kind is known from German Offenlegungsschrift (published Patent Application) DE 35 46 095.

Generally speaking, specimen supports must be capable of moving the specimen in three directions: the direction of the particle beam (the z-axis), the direction of the axis of the specimen support of the specimen holder (the x-axis), and the direction perpendicular to said two axes (the y-axis).

In the cited Patent Appliction the motions in the y-direction and the z-direction are realised by tilting the housing about a ball joint forming part of the housing. Because the axis of this tilt is situated outside the optical axis of the particle-optical instrument (and hence outside the specimen), this tilt causes a displacement of the specimen in the y-direction and/or the z-direction. In this specimen holder it is also possible to rotate the specimen about the x-axis. To this end, the drive for this rotation is connected to the exterior of the housing *via* a bellows. The object is to achieve a torsion-resistant transmission which does not impede said tilting motions.

The displacement of the specimen support in the x-direction is guided by a V-groove in the ball forming part of the ball joint. For displacement in the x-direction there is provided a specimen support displacement device which operates against the ambient air pressure acting on the specimen support. The cited Patent Application does not disclose how the vacuum seal between the specimen support and the housing is realised. Generally speaking, this type of seal is customarily realised by means of an O-ring between the specimen support and the housing. For accurately defined and accurately reproducible displacements, O-rings have some drawbacks: some force is required to overcome the initial friction at the start of motion of the O-ring and the material of the O-ring always exhibits some relaxation, so that the initial x-position of the specimen support is lost.

It is an object of the invention to provide a particle-optical apparatus with a specimen holder of the kind set forth in which the x-positioning of the specimen is defined in a more accurate and more reproducible manner. To achieve this, the apparatus in accordance with the invention is characterized in that the specimen support is connected to the housing *via* a bellows.

The effect of this step consists in that the vacuum sealing is thus independent from the x-displacement.
Vacuum sealing can now be realised in any known manner, for example by means of an O-ring.

A further improvement of the positioning of the specimen is achieved in that the other end of the specimen support is supported in a further V-groove. It is thus achieved that any parasitic forces (being forces acting in a direction other than the desired direction) will cause substantially smaller parasitic displacements.

In contemporary particle-optical apparatus, such as high-resolution electronmicroscopes, the end of the specimen support is often loaded by a variety of additional equipment which substantially contributes to the force exerted on the V-groove by the other end of the specimen support. The friction experienced by the specimen support upon displacement in the x-direction can be further reduced in accordance with the invention in that the further V-groove is constructed as a V-roller.

A further refinement of the x-motion can be achieved by providing a differential gear between the drive mechanism for the x-displacement, if any, and the specimen support. The occurrence of parasitic forces is thus strongly reduced, so that parasitic displacements are reduced even further.

The invention will be described in detail hereinafter with reference to the Figures. Therein:
Figure 1 shows diagrammatically a particle-optical apparatus in accordance with the invention, and
Figure 2 is a sectional view of the specimen holder to be used in the particle-optical apparatus shown in Figure 1.

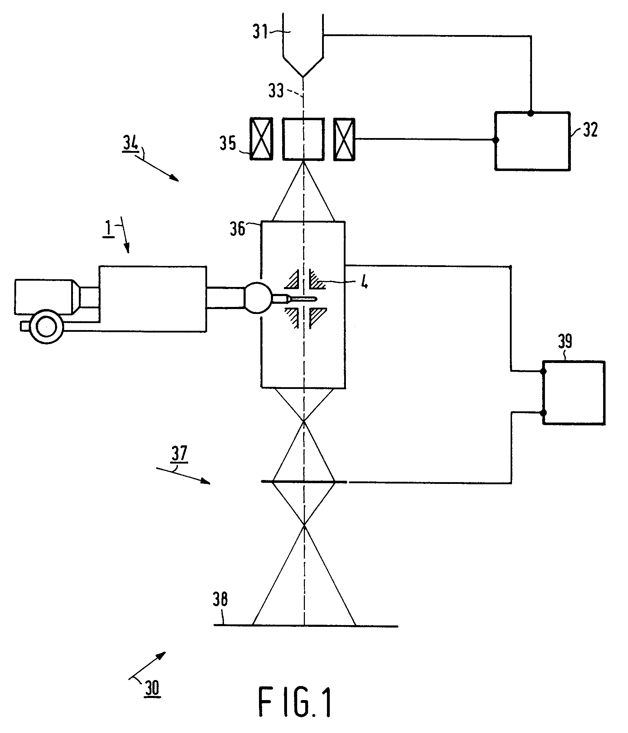

The particle-optical apparatus 30 diagrammatically shown in Figure 1 comprises an electron source 31 which is driven by a high-voltage generator 32 so as to generate an electron beam 33, and also comprises an electron-optical system 34 for directing the beam 33 onto an object arranged in a specimen holder 1. The electron-optical system is composed of a condenser system 35 and an objective lens 36 whose poles 4 are diagrammatically indicated. After their passage through the object, the electrons are imaged on an image plane 38 by the objective lens and a further lens system 37. The lenses are energized by a lens power supply 39.

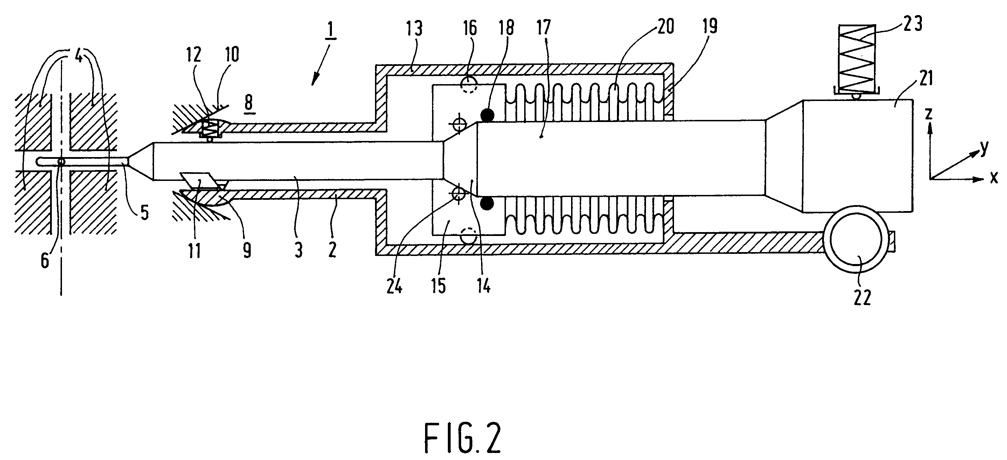

Figure 2 shows a specimen holder 1 which consists essentially of a housing 2 and a specimen support 3 accommodated within the housing. An end 5 of the specimen support supports the specimen 6 which is thus positioned between the poles 4 of the particle lens of the particle-optical apparatus. The x, the y and the z-direction in which the specimen is to be movable are shown to the right of the specimen holder in the Figure. Displacement of the specimen in the z-direction and the y-direction is possible in that the housing 2 is provided with a ball joint 8 which is formed by a ball 9 arranged in a cavity formed by the conical surface 10. This conical surface is rigidly connected to the particle-optical system. When the housing is moved, in the plane of drawing, about the centre of the ball joint, a displacement in the z-direction takes place. The same holds for the y-direction when the housing is moved perpendicularly to the plane of drawing.

Within the ball 9 of the ball joint 8 the specimen support is supported in a V-groove 11; this V-groove is formed, for example by two polished surfaces forming part of the interior of the ball 9. The specimen support 3 is positioned in the V-groove in a play-free manner by means of a pressure spring 12.

The mechanism for the x-motion and the vacuum passage are provided in a widened portion 13 of the housing 2. Around a conical thickened portion 14 of the specimen support 3 there is provided a cylindrical flange 15. *Via* a guide 16, for example ball bearings, the flange can reciprocate in the x-direction. Between the flange 15 and the thickened portion 17 of the specimen support 3 there is provided an O-ring 18 for vacuum sealing. Between the flange 15 and an outwards directed edge 19 of the housing 2 there is provided an airtight bellows 20. The bellows enables displacement of the specimen support 3 in the x-direction, without the specimen support necessarily rubbing against a vacuum seal.

The rear side 21 of the specimen support 3 is supported on a V-roller 22 which is rigidly connected to the housing 2. The rear side 21 is pressed into the V-roller 22 by a pressure spring 23 which is connected to the housing 2 in a manner not shown in the Figure.

In the cylindrical flange 15 there are provided bores which are situated to both sides of the conical thickened portion 14. Round pins 24 are provided in these bores so that the surface of the pins bears on the conical surface of the thickened portion 14. The tensile force in the x-direction is thus transmitted to the specimen support 3 of the specimen holder.

## Claims

1. A particle-optical apparatus, with a specimen holder which comprises a housing (2) which is movable relative to the apparatus in a first and a second, mutually perpendicular direction, and also comprises a rod-shaped specimen support (3) for supporting the specimen (6), which support is accommodated in the tubular housing (2) and is movable in a third direction, perpendicularly to the first and the second direction, said specimen support (3) being supported, by way of its end facing the optical axis of the apparatus, in a V-groove (11) whose groove direction is the third direction, characterized in that the specimen support (3) is connected to the housing (2) *via* a bellows.

2. A particle-optical apparatus as claimed in Claim 1, characterized in that the other end (21) of the specimen support (3) is supported in a further V-groove (22).

3. A particle-optical apparatus as claimed in Claim 2, characterized in that the further V-groove (22) is constructed as a V-roller.

4. A particle-optical apparatus as claimed in any one of the preceding Claims, comprising a drive mechanism for the x-displacement, characterized in that a differential gear is provided between the drive mechanism and the specimen support.

5. A specimen holder for a particle-optical apparatus as claimed in any one of the Claims 1 to 4.
